# EUROPEAN PATENT APPLICATION

(11) **EP 3 960 445 A1**
(43) Date of publication of application: **02.03.2022**
(21) Application number: 20796089.9
(22) Date of filing: 06.04.2020
(51) Int. Cl.: B32B 27/00, C09J 133/00, C09J 201/00, H01L 21/56, C09J 7/38, B32B 7/12, H05K 3/28

(54) **ADHESIVE FILM AND METHOD FOR MANUFACTURING ELECTRONIC DEVICE**

(30) Priority: 26.04.2019 JP 2019086215
(71) Applicant: Mitsui Chemicals Tohcello, Inc., Tokyo 101-8485 (JP)
(72) Inventor: MIURA Toru, Nagoya-shi, Aichi 457-0801 (JP); IGARASHI Kouji, Tokyo 101-8485 (JP); KURIHARA Hiroyoshi, Nagoya-shi, Aichi 457-0801 (JP)
(74) Representative: Hoffmann Eitle
(86) International application number: PCT/JP2020/015553
(87) International publication number: WO 2020/217955

(57) **Abstract**

An adhesive film (50) of the present invention includes a base material layer (10), an adhesive resin layer (A) provided on a first surface (10A) side of the base material layer (10), and an adhesive resin layer (B) provided on a second surface (10B) side of the base material layer (10) and of which an adhesive force is reduced by an external stimulus. When a mass of the adhesive film (50) after heating and drying at 130°C for 30 minutes is defined as W₁ and the mass of the adhesive film (50) after the heated and dried adhesive film (50) is left for 24 hours at 25°C under an atmosphere of 50% RH to absorb water is defined as W₂, an average water absorption rate indicated by 100 x (W₂-W₁)/W₁ is 0.90% by mass or less.

## Description

### TECHNICAL FIELD

The present invention relates to an adhesive film and a method for manufacturing an electronic device.

### BACKGROUND ART

As a technology which is able to reduce the size and weight of electronic devices (for example, semiconductor apparatuses), a fan-out type WLP (wafer level package) is being developed.

In an eWLB (Embedded Wafer Level Ball Grid Array), which is one of the methods for manufacturing a fan-out type WLP, it is possible to adopt a method in which a plurality of electronic components such as semiconductor chips are temporarily fixed in a separated state on an adhesive film attached to a support substrate, and the plurality of electronic components are sealed in a batch with a sealing material. Here, the adhesive film needs to be fixed to the electronic component and the support substrate in the sealing step or the like and needs to be removed from the sealed electronic component and the support substrate after the sealing.

Examples of a technique related to such a fan-out type WLP manufacturing method include the technique described in Patent Document 1.

Patent Document 1 discloses a heat-resistant adhesive sheet for manufacturing a semiconductor apparatus, which is used by being attached when resin-sealing a substrateless semiconductor chip, in which the heat-resistant adhesive sheet has a base material layer and an adhesive layer, and the adhesive layer has an adhesive force to SUS304 after bonding of 0.5 N/20 mm or more, is cured by a stimulus received until the completion of a resin sealing step, and has a peeling force with respect to a package of 2.0 N/20 mm or less.

### RELATED DOCUMENT

### PATENT DOCUMENT

[Patent Document 1] Japanese Patent Laid-Open No. 2011-134811

### SUMMARY OF THE INVENTION

### TECHNICAL PROBLEM

According to studies by the inventors of the present invention, it was found that, when electronic components are arranged on an adhesive film and the electronic components are sealed with a sealing material, the positions of the electronic components may shift (also referred to below as position shifting of the electronic components) .

The present invention is made in consideration of the above circumstances and provides an adhesive film that enables to suppress position shifting of electronic components in a sealing step.

### SOLUTION TO PROBLEM

The inventors of the present invention carried out intensive studies in order to achieve the above object. As a result, it was found that, in an adhesive film formed by providing adhesive resin layers on both surfaces of a base material layer, it is possible to solve the problem described above by setting the water absorption rate of the film in a specific range, thereby completing the present invention.

According to the present invention, there is provided an adhesive film and a method for manufacturing an electronic device as shown below.

[1] An adhesive film including a base material layer, an adhesive resin layer (A) provided on a first surface side of the base material layer, and an adhesive resin layer (B) provided on a second surface side of the base material layer and of which an adhesive force is reduced by an external stimulus, in which, when a mass of the adhesive film after being heated and dried at 130°C for 30 minutes is defined as W₁ and a mass of the adhesive film after the heated and dried adhesive film is left for 24 hours at 25°C under an atmosphere of 50% RH to absorb water is defined as W₂, an average water absorption rate indicated by 100 × (W₂-W₁)/W₁ is 0.90% by mass or less.
[2] The adhesive film according to [1], in which the adhesive film is used to temporarily fix an electronic component when the electronic component is sealed by a sealing material in an electronic device manufacturing process.
[3] The adhesive film according to [1] or [2], in which the base material layer includes a uniaxially stretched or biaxially stretched polyester film.
[4] The adhesive film according to any one of [1] to [3], in which the adhesive force of the adhesive resin layer (B) is reduced upon being heated at a temperature exceeding 180°C.
[5] The adhesive film according to [4], in which the adhesive resin layer (B) includes at least one selected from a gas generating component and heat-expandable microspheres.
[6] The adhesive film according to any one of [1] to [5], in which a content of at least one selected from a gas generating component and heat-expandable microspheres in the adhesive resin layer (A) is 0.1% by mass or less when the entire adhesive resin layer (A) is 100% by mass.
[7] The adhesive film according to any one of [1] to [6], in which the adhesive resin layer (A) includes a (meth) acrylic-based adhesive resin.
[8] A method for manufacturing an electronic device, the method including at least: a step (1) of preparing a structure provided with the adhesive film according to any one of [1] to [7], an electronic component attached to the adhesive resin layer (A) of the adhesive film, and a support substrate attached to the adhesive resin layer (B) of the adhesive film, a step (2) of sealing the electronic component with a sealing material, a step (3) of peeling the support substrate from the structure by reducing an adhesive force of the adhesive resin layer (B) by applying an external stimulus, and a step (4) of peeling the adhesive film from the electronic component.
[9] The method for manufacturing an electronic device according to [8], in which the sealing material is an epoxy resin-based sealing material.

### ADVANTAGEOUS EFFECTS OF INVENTION

According to the present invention, it is possible to provide an adhesive film with which it is possible to suppress position shifting of electronic components in a sealing step.

### BRIEF DESCRIPTION OF THE DRAWINGS

Fig. 1 is a cross-sectional view schematically showing an example of a structure of an adhesive film of an embodiment according to the present invention.
Fig. 2 is a cross-sectional view schematically showing an example of a method for manufacturing an electronic device of an embodiment according to the present invention.
Fig. 3 is a cross-sectional view schematically showing an example of a method for manufacturing an electronic device of an embodiment according to the present invention.

### DESCRIPTION OF EMBODIMENTS

A description will be given below of embodiments of the present invention with reference to the drawings. In all the drawings, common reference numerals are given to the same constituent components and description thereof will not be repeated. In addition, the figures are schematic views and do not match the actual dimensional ratios. In addition, unless otherwise specified, "A to B" in the numerical range represents A or more and B or less. In addition, in the present embodiment, "(meth)acrylic" means acrylic, methacrylic, or both acrylic and methacrylic.

### 1. Adhesive film

A description will be given below of an adhesive film 50 according to the present embodiment.

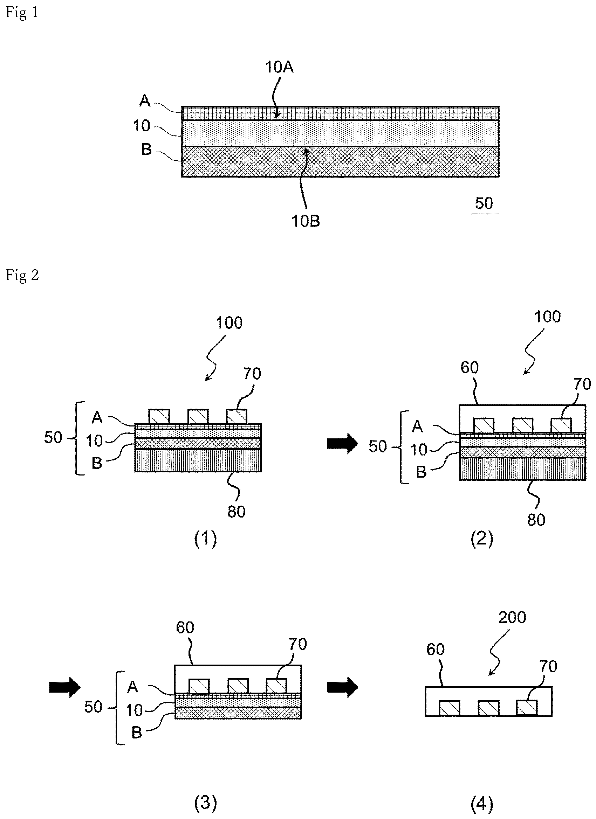

Fig. 1 is a cross-sectional view schematically showing an example of the structure of the adhesive film 50 of the embodiment according to the present invention.

As shown in Fig. 1, the adhesive film 50 according to the present embodiment is provided with a base material layer 10, an adhesive resin layer (A) provided on a first surface 10A side of the base material layer 10, and an adhesive resin layer (B) provided on a second surface 10B side of the base material layer 10 and of which an adhesive force is reduced by an external stimulus, in which, when a mass of the adhesive film 50 after heating and drying at 130°C for 30 minutes is defined as W₁ and the mass of the adhesive film 50 after the heated and dried adhesive film 50 is left for 24 hours at 25°C under an atmosphere of 50% RH to absorb water is defined as W₂, an average water absorption rate indicated by 100 × (W₂-W₁)/W₁ is 0.90% by mass or less.

As described above, according to studies by the inventors of the present invention, it was clear that, when electronic components are arranged on an adhesive film and the electronic components are sealed with a sealing material, the positions of the electronic components may shift.

Therefore, the inventors of the present invention carried out intensive studies to realize an adhesive film with which it is possible to suppress position shifting of electronic components in a sealing step. As a result, it was found for the first time that, in the adhesive film 50 provided with the base material layer 10, the adhesive resin layer (A) provided on the first surface 10A side of the base material layer 10, and the adhesive resin layer (B) provided on the second surface 10B side of the base material layer 10 and of which an adhesive force is reduced by an external stimulus, the criterion of the average water absorption rate indicated by 100 × (W₂-W₁)/W₁ is effective as a design guideline for the adhesive film for suppressing position shifting of electronic components in a sealing step.

That is, it is possible for the adhesive film 50 according to the present embodiment to suppress the position shifting of electronic components in the sealing step by configuring the average water absorption rate described above to be the upper limit value described above or less.

Although the reasons why it is possible to suppress position shifting of the electronic components in the sealing step by using the adhesive film 50 according to the present embodiment are not clear, the following reasons are considered.

First, it is considered that position shifting of electronic components occurs due to mechanisms such as: 1) moisture included in the adhesive film expands due to decompression or heating, which generates bubbles at the interface between the support substrate and the adhesive resin layer, making it easier for the adhesive film to peel off from the support substrate; and 2) bubbles form at the interface between the adhesive resin layer on the electronic component side and the electronic component and the electronic component is pushed up, such that the electronic component jumps or sealing resin penetrates a floating portion and buries the electronic component. On the other hand, since water absorption is controlled in the adhesive film 50 according to the present embodiment, it is possible to suppress the generation of bubbles derived from moisture and, as a result, it is considered that it is possible to suppress the position shifting of the electronic components in the sealing step.

For the above reasons, it is considered that it is possible to suppress the position shifting of electronic components in a sealing step by using the adhesive film 50 according to the present embodiment.

In the present embodiment, the average water absorption rate, indicated by 100 × (W₂-W₁)/W₁, is preferably 0.75% by mass or less, and more preferably 0.65% by mass or less. Since a lower average water absorption rate is more preferable, the lower limit value is not particularly limited and, for example, may be 0.01% by mass or more, or may be 0.10% by mass or more.

It is possible to determine the average water absorption rate, for example, by the following procedure.
1) The adhesive film 50 is left in a clean room for 24 hours at 25°C under an atmosphere of 50% RH. In a case where a separator is attached to the adhesive film 50, the film is left in a state where the separator is attached.
2) Heating is carried out in an oven set at 130°C for 30 minutes to remove the moisture in the adhesive film 50. Next, the mass of the adhesive film 50 after heating and drying is measured and this mass is set as W₁. Here, in a case where a separator is attached to the adhesive film 50, the heating and drying treatment is performed after peeling off the separator.
3) The mass of the adhesive film 50 is measured after the heated and dried adhesive film 50 is left for 24 hours in the clean room described above at 25°C and under an atmosphere of 50% RH to absorb water. This mass is set as W₂.
4) 100 × (W₂-W₁) /W₁ is the absorption rate. The same measurement is repeated six times for each adhesive film and the average thereof is the average water absorption rate.

In the adhesive film 50 according to the present embodiment, it is possible to adjust the average water absorption rate by controlling the composition of the adhesive resin layer (A) and the adhesive resin layer (B) ; the type and content of gas generating components or heat-expandable microspheres able to be included in the adhesive resin layer (B) ; the thickness of the adhesive resin layer (B) , and the like.

As the adhesive resin forming the adhesive resin layer (A), it is possible to preferably use a (meth)acrylic-based adhesive resin (a), as described below. For the (meth) acrylic-based adhesive resin (a), a copolymer having a (meth) acrylic acid alkyl ester monomer as a constituent unit is used. It is desirable that the content of the polar monomer (for example, a monomer including a hydroxyl group, a carboxyl group, or an amide group such as a monomer (a2) described below) units included in the copolymer described above be 40% by mass or less, preferably 20% by mass or less, and even more preferably 10% by mass or less.

As the adhesive resin which forms the adhesive resin layer (B), it is possible to preferably use a (meth) acrylic-based adhesive resin (b), as described below. For the (meth) acrylic-based adhesive resin (b), a copolymer having a (meth) acrylic acid alkyl ester monomer as a constituent unit is used. It is desirable that the ratio of the polar monomer (for example, a monomer including a hydroxyl group, a carboxyl group, or an amide group such as a monomer (b2) described below) units included in the copolymer described above be 40% by mass or less, preferably 20% by mass or less, and even more preferably 10% by mass or less.

In a case of using inorganic peroxide, described below, as a polymerization initiator when polymerizing the (meth)acrylic-based adhesive resin (a) and the (meth)acrylic-based adhesive resin (b), it is preferable to use 1% by mass or less with respect to the total amount of monomers.

Since heat-expandable microspheres included in the adhesive resin layer (B) use materials with relatively high hydrophilicity such as, for example, polyvinyl butyral, polyvinyl alcohol, and polyacrylonitrile as a shell, the blending amount of the heat-expandable microspheres is preferably 30% by mass or less with respect to the adhesive resin layer (B) , and more preferably 20% by mass or less. The lower limit of the blending amount of heat-expandable microspheres is preferably 5% by mass or more with respect to the adhesive resin layer (B) , and more preferably 10% by mass or more.

In addition, since the heat-expandable microspheres included in the adhesive resin layer (B) easily absorb water, the thicker the adhesive resin layer (B) is, the larger the average water absorption rate of the adhesive film 50 according to the present embodiment becomes. Thus, adjusting the thickness of the adhesive resin layer (B) in the entire adhesive film makes it possible to adjust the average water absorption rate of the adhesive film 50 according to the present embodiment.

For example, in a case where the blended amount of microspheres is approximately 15% by mass with respect to the adhesive resin layer (B) , when the thickness of the adhesive resin layer (B) is X and the thickness of an unevenness-absorbing layer described below is Y, X/Y is preferably approximately 1.0 to 1.8, and more preferably 1.0 to 1.5.

In a case where there is no unevenness-absorbing layer, when the thickness of the adhesive resin layer (A) is Z, X/Z is preferably approximately 1.0 to 2.2, and more preferably 1.0 to 2.1.

Even in a case where the blending amount of the microspheres is different, it is possible to adjust the average water absorption rate by appropriately adjusting the thickness ratio described above.

The thickness of the adhesive film 50 according to the present embodiment as a whole is preferably 10 µm or more and 1000 µm or less, and more preferably 20 µm or more and 500 µm or less, from the viewpoint of balancing mechanical properties and handling properties.

It is possible to use the adhesive film 50 according to the present embodiment, for example, as a film for temporarily fixing an electronic component when the electronic component is sealed by a sealing material in an electronic device manufacturing step, in particular, suitable use is possible as a film for temporarily fixing an electronic component in a step of manufacturing a fan-out type WLP or a fan-out type PLP.

Next, a description will be given of each layer forming the adhesive film 50 according to the present embodiment.

### <Base Material Layer>

The base material layer 10 is a layer provided for the purpose of making the characteristics such as the handling, mechanical properties, heat resistance, and the like of the adhesive film 50 more favorable.

The base material layer 10 is not particularly limited and examples thereof include a resin film.

As the resin forming the resin film described above, it is possible to use a known thermoplastic resin. Examples thereof include one type or two or more types selected from polyolefins such as polyethylene, polypropylene, poly(4-methyl-1-pentene), and poly(1-butene); polyesters such as polyethylene terephthalate, polybutylene terephthalate, and polyethylene naphthalate; polyamides such as nylon-6, nylon-66, and polymetaxylene adipamide; polyacrylates; polymethacrylates; polyvinyl chlorides; polyvinylidene chlorides; polyimides; polyetherimides; ethylene vinyl acetate copolymers; polyacrylonitrile; polycarbonates; polystyrenes; ionomers; polysulfones; polyethersulfone; polyphenylene ether, and the like.

Among these, from the viewpoint of an excellent balance between the low shrinkage property, mechanical strength, price, and the like, polyesters such as polyethylene terephthalate, polybutylene terephthalate, and polyethylene naphthalate are preferable, and polyethylene terephthalate and polybutylene terephthalate are more preferable.

The base material layer 10 may be a single layer or a layer of two or more types.

In addition, the form of the resin film used to form the base material layer 10 is preferably a stretched film stretched in the uniaxial or biaxial direction from the viewpoint of an excellent balance between the low shrinkage property, mechanical strength, and the like of the base material layer 10.

As the resin film used to form the base material layer 10, from the viewpoint of excellent balance of the low shrinkage property, mechanical strength, price, and the like, a uniaxially stretched or biaxially stretched polyester film is even more preferable and a uniaxially stretched or biaxially stretched polyethylene terephthalate (PET) film is particularly preferable.

The shrinkage ratio in the direction that the thermal shrinkage of the base material layer 10 is the maximum, as measured under the conditions of heating at 150°C for 30 minutes in accordance with JIS C2151, is preferably 0.0% or more and 1.3% or less, and more preferably 0.0% or more and 1.3% or less. When the shrinkage ratio in the direction that the thermal shrinkage of the base material layer 10 is the maximum is within the above range, it is easy to control the shrinkage ratio in the direction that the thermal shrinkage of the adhesive film 50 is the maximum within the range described above, which is preferable.

Here, in an MD direction of the resin film for forming the base material layer 10, applying winding stress during film formation tends to leave residual stress and increase shrinkage after film formation, thus, the direction that the thermal shrinkage of the base material layer 10 is the maximum is often the MD direction of the resin film for forming the base material layer 10.

In addition, in a case where the resin film for forming the base material layer 10 is a uniaxially stretched film or a biaxially stretched film, the direction that the thermal shrinkage of the base material layer 10 is the maximum is often the direction that the degree of stretching is the largest.

Here, it is possible to control the shrinkage ratio in the direction that the thermal shrinkage of the base material layer 10 is the maximum, for example, by performing a stress relaxation treatment such as a heat treatment with respect to the resin film used to form the base material layer 10 and reducing the thermal stress.

In a case where the resin film used to form the base material layer 10 is a uniaxially stretched or biaxially stretched polyethylene terephthalate (PET) film, the heat treatment temperature is, for example, equal to or more than 140°C and equal to or less than 240°C, and the heat treatment time is, for example, 10 seconds or more and 200 seconds or less.

From the viewpoint of obtaining favorable film properties, the thickness of the base material layer 10 is preferably 1 µm or more and 500 µm or less, more preferably 5 µm or more and 300 µm or less, and even more preferably 10 µm or more and 250 µm or less.

The base material layer 10 may be subj ected to a surface treatment in order to improve the adhesion with other layers. Specifically, a corona treatment, a plasma treatment, an undercoat treatment, a primer coat treatment, and the like may be performed.

### <Adhesive resin layer (A)>

The adhesive resin layer (A) is a layer provided on one surface side of the base material layer 10 and, for example, is for contacting the surface of the electronic component to temporarily fix the electronic component when the electronic component is sealed with a sealing material in the electronic device manufacturing steps.

The adhesive resin layer (A) includes an adhesive resin (A1).

Examples of the adhesive resin (A1) include a (meth)acrylic-based adhesive resin (a), a silicone-based adhesive resin, a urethane-based adhesive resin, an olefin-based adhesive resin, a styrene-based adhesive resin, and the like.

Among the above, the (meth)acrylic-based adhesive resin (a) is preferable from the viewpoint of facilitating the adjustment of the adhesive force or the like.

As the adhesive resin layer (A), it is also possible to use a radiation cross-linking adhesive resin layer that the adhesive force is reduced by radiation. The radiation cross-linking adhesive resin layer is cross-linked by the irradiation of radiation and the adhesive force is significantly reduced, thus, the adhesive film 50 is easily peeled from the electronic component. Examples of the radiation include ultraviolet rays, electron beams, infrared rays, and the like.

As the radiation cross-linking adhesive resin layer, an ultraviolet cross-linking adhesive resin layer is preferable.

Examples of the (meth)acrylic-based adhesive resin (a) used in the adhesive resin layer (A) include a copolymer including a (meth) acrylic acid alkyl ester monomer unit (a1) and a monomer unit (a2) having a functional group capable of reacting with a cross-linking agent.

In the present embodiment, the (meth)acrylic acid alkyl ester means an acrylic acid alkyl ester, a methacrylic acid alkyl ester, or a mixture thereof.

It is possible to obtain the (meth) acrylic-based adhesive resin (a) according to the present embodiment, for example, by copolymerizing a monomer mixture including a (meth) acrylic acid alkyl ester monomer (a1) and a monomer (a2) having a functional group capable of reacting with a cross-linking agent.

Examples of the monomer (a1) forming the (meth)acrylic acid alkyl ester monomer unit (a1) include a (meth) acrylic acid alkyl ester having an alkyl group having approximately 1 to 12 carbon atoms. A (meth)acrylic acid alkyl ester having an alkyl group having 1 to 8 carbon atoms is preferable. Specific examples thereof include methyl acrylate, methyl methacrylate, ethyl acrylate, ethyl methacrylate, butyl acrylate, butyl methacrylate, 2-ethylhexyl acrylate, 2-ethylhexyl methacrylate, and the like. These may be used alone or in a combination of two or more types. In the (meth) acrylic-based adhesive resin (a) according to the present embodiment, when the total of all the monomer units in the (meth)acrylic-based adhesive resin (a) is 100% by mass, the content of the (meth) acrylic acid alkyl ester monomer unit (a1) is preferably 10% by mass or more and 98.9% by mass or less, more preferably 50% by mass or more and 97% by mass or less, and even more preferably 85% by mass or more and 95% by mass or less.

Examples of the monomer (a2) forming the monomer (a2) having a functional group capable of reacting with the cross-linking agent include acrylic acid, methacrylic acid, itaconic acid, mesaconic acid, citraconic acid, fumaric acid, maleic acid, itaconic acid monoalkyl ester, mesaconic acid monoalkyl ester, citraconic acid monoalkyl ester, fumaric acid monoalkyl ester, maleic acid monoalkyl ester, glycidyl acrylate, glycidyl methacrylate, 2-hydroxyethyl acrylate, 2-hydroxyethyl methacrylate, acrylamide, methacrylamide, tert-butylaminoethyl acrylate, tert-butylaminoethyl methacrylate, and the like. Preferable are acrylic acid, methacrylic acid, 2-hydroxyethyl acrylate, 2-hydroxyethyl methacrylate, acrylamide, methacrylamide, and the like. These may be used alone or in a combination of two or more types.

In the (meth)acrylic-based adhesive resin (a) according to the present embodiment, when the total of all the monomer units in the (meth)acrylic-based adhesive resin (a) is 100% by mass, the content of the monomer unit (a2) is preferably 1% by mass or more and 40% by mass or less, more preferably 1% by mass or more and 20% by mass or less, and even more preferably 1% by mass or more and 10% by mass or less.

The (meth)acrylic-based adhesive resin (a) according to the present embodiment may, in addition to the monomer unit (a1) and the monomer unit (a2), further include a bifunctional monomer unit (a3) and a specific comonomer (referred to below as a polymerizable surfactant) unit having properties as a surfactant.

The polymerizable surfactant has a property of copolymerizing with the monomer (a1), the monomer (a2), and the monomer (a3), and also has an action as an emulsifier in the case of emulsion polymerization.

Examples of the monomer (a3) forming the bifunctional monomer unit (a3) include allyl methacrylate, allyl acrylate, divinylbenzene, vinyl methacrylate, vinyl acrylate, trimethylolpropane tri(meth)acrylate, pentaerythritol tri(meth)acrylate, dipentaerythritol hexa(meth)acrylate, tetraethylene glycol di(meth)acrylate, or, for example, monomers that the main chain structure is a propylene glycol type with diacrylate or dimethacrylate at both ends (for example, manufactured by NOF Corp., trade name: PDP-200, PDP-400, ADP-200, and ADP-400), tetramethylene glycol type monomers (for example, manufactured by NOF Corp., trade name: ADT-250 and ADT-850), mixtures thereof (for example, manufactured by NOF Corp., trade name: ADET-1800 and ADPT-4000), and the like.

In the (meth)acrylic-based adhesive resin (a) according to the present embodiment, when the total of all the monomer units in the (meth)acrylic-based adhesive resin (a) is 100% by mass, the content of the monomer unit (a3) is preferably 0.1% by mass or more and 30% by mass or less, more preferably 0.1% by mass or more and 15% by mass or less, even more preferably 0.1% by mass or more and 20% by mass or less, and particularly preferably 0.1% by mass or more and 5% by mass or less.

Examples of the polymerizable surfactant include a surfactant that a polymerizable 1-propenyl group is introduced into a benzene ring of polyoxyethylene nonylphenyl ether (manufactured by Daiichi Kogyo Seiyaku Co., Ltd., trade name: Aqualon RN-10, RN-20, RN-30, RN-50, and the like), a surfactant that a polymerizable 1-propenyl group is introduced into a benzene ring of ammonium salt of sulfuric acid ester of polyoxyethylene nonylphenyl ether (manufactured by Daiichi Kogyo Seiyaku Co., Ltd., trade name: Aqualon HS-10, HS-20, HS-1025, and the like), and a sulfosuccinate diester-based surfactant having a polymerizable double bond in the molecule (manufactured by Kao Corp., trade name: Latemul S-120A, S-180A, and the like), or the like.

In the (meth)acrylic-based adhesive resin (a) according to the present embodiment, when the total of all monomer units in the (meth)acrylic-based adhesive resin (a) is 100% by mass, the content of the polymerizable surfactant is preferably 0.1% by mass or more and 30% by mass or less, more preferably 0.1% by mass or more and 15% by mass or less, even more preferably 0.1% by mass or more and 20% by mass or less, and particularly preferably 0.1% by mass or more and 5% by mass or less.

The (meth)acrylic-based adhesive resin (a) according to the present embodiment may further contain a monomer unit formed of a monomer having a polymerizable double bond such as vinyl acetate, acrylonitrile, or styrene, as necessary.

Examples of the polymerization reaction mechanism of the (meth)acrylic-based adhesive resin (a) according to the present embodiment include radical polymerization, anionic polymerization, cationic polymerization, and the like. In consideration of the manufacturing cost of the (meth)acrylic-based adhesive resin, the influence of the functional group of the monomer, the influence of ions on the surface of the electronic component, and the like, it is preferable to carry out the polymerization by radical polymerization.

When polymerizing by a radical polymerization reaction, examples of radical polymerization initiators include organic peroxides such as benzoyl peroxide, di-t-butyl peroxide, dicumyl peroxide, 3,3,5-trimethylhexanoyl peroxide, di-2-ethylhexylperoxy dicarbonate, methyl ethyl ketone peroxide, t-butylperoxyphthalate, t-butylperoxybenzoate, di-t-butylperoxyacetate, t-butylperoxyisobutyrate, t-butylperoxy-2-hexanoate, t-butylperoxy-2-ethylhexanoate, t-butylperoxy-3,5,5-trimethylhexanoate, acetyl peroxide, isobutyryl peroxide, octanoyl peroxide, t-butyl peroxide, and di-t-amyl peroxide; inorganic peroxides such as ammonium persulfate, potassium persulfate, and sodium persulfate; and azo compounds such as 2,2'-azobisisobutyronitrile, 2,2'-azobis-2-methylbutyronitrile, and 4,4'-azobis-4-cyanovaleric acid.

In a case of polymerizing by an emulsion polymerization method, among these radical polymerization initiators, inorganic peroxides such as water-soluble ammonium persulfate, potassium persulfate, and sodium persulfate, and azo compounds having a carboxyl group in the molecule such as water-soluble 4,4'-azobis-4-cyanovaleric acid are preferable. Considering the influence of ions on the surface of the electronic components, ammonium persulfate and azo compounds having a carboxyl group in the molecule such as 4,4'-azobis-4-cyanovaleric acid are more preferable, and azo compounds having a carboxyl group in the molecule such as 4,4'-azobis-4-cyanovaleric acid are particularly preferable.

The adhesive resin layer (A) according to the present embodiment preferably further includes a cross-linking agent (A2) having two or more cross-linkable functional groups in one molecule, in addition to the adhesive resin (A1).

The cross-linking agent (A2) having two or more cross-linkable functional groups in one molecule is used to react with the functional group of the adhesive resin (A1) and adjust the adhesive force and aggregating force.

Examples of such a cross-linking agent (A2) include epoxy-based compounds such as sorbitol polyglycidyl ether, polyglycerol polyglycidyl ether, pentaerythritol polyglycidyl ether, diglycerol polyglycidyl ether, glycerol polyglycidyl ether, neopentyl glycol diglycidyl ether, and resorcinol diglycidyl ether; isocyanate-based compounds such as tetramethylene diisocyanate, hexamethylene diisocyanate, toluene diisocyanate 3 adduct of trimethylolpropane, polyisocyanate, diphenylmethane diisocyanate, and tolylene diisocyanate; aziridine-based compounds such as trimethylolpropane-tri-p-aziridinylpropionate, tetramethylolmethane-tri-p-aziridinylpropionate, N,N'-diphenylmethane-4,4'-bis(1-aziridinecarboxamide), N,N'-hexamethylene-1,6-bis(1-aziridinecarboxamide), N,N'-toluene-2,4-bis(1-aziridinecarboxamide), and trimethylolpropane-tri-β-(2-methylaziridine) propionate; tetrafunctional epoxy-based compounds such as N,N,N',N'-tetraglycidyl-m-xylenediamine and 1,3-bis(N,N'-diglycidylaminomethyl) cyclohexane; and melamine-based compounds such as hexamethoxymethylolmelamine. These may be used alone or in a combination of two or more types. Among the above, one type or two or more types selected from epoxy-based compounds, isocyanate-based compounds, and aziridine-based compounds are preferably included.

The content of the cross-linking agent (A2) is usually preferably within a range where the number of functional groups in the cross-linking agent (A2) does not become larger than the number of functional groups in the adhesive resin (A1). However, in a case where new functional groups are created in the cross-linking reaction, a case where the cross-linking reaction is slow, and the like, the content thereof may be greater as necessary.

From the viewpoint of improving the balance between the heat resistance and adhesion of the adhesive resin layer (A), the content of the cross-linking agent (A2) in the adhesive resin layer (A) is preferably 0.1 parts by mass or more and 15 parts by mass or less with respect to 100 parts by mass of the adhesive resin (A1).

The total content of the adhesive resin (A1) and the cross-linking agent (A2) in the adhesive resin layer (A) is preferably 50% by mass or more and 100% by mass or less when the entire adhesive resin layer (A) is 100% by mass, more preferably 70% by mass or more and 100% by mass or less, even more preferably 90% by mass or more and 100% by mass or less, and particularly preferably 95% by mass or more and 100% by mass or less. Due to this, it is possible to further suppress glue residue on the electronic component side when the adhesive film is peeled from the electronic component.

The thickness of the adhesive resin layer (A) is not particularly limited, but is, for example, preferably 1 µm or more and 100 µm or less, and more preferably 3 µm or more and 50 µm or less.

It is possible to form the adhesive resin layer (A), for example, by coating a pressure sensitive adhesive on the base material layer 10. The pressure sensitive adhesive may be dissolved in a solvent and coated as a coating solution or may be coated as an aqueous emulsion, or the liquid pressure sensitive adhesive may be coated directly.

Among the above, an aqueous emulsion coating solution is preferable. Examples of aqueous emulsion coating solutions include a coating solution that the (meth)acrylic-based adhesive resin (a), a silicone-based adhesive resin, a urethane-based adhesive resin, an olefin-based adhesive resin, a styrene-based adhesive resin, or the like is dispersed in water. A pressure sensitive adhesive coating solution dissolved in an organic solvent may be used. The organic solvent is not particularly limited and may be appropriately selected from known organic solvents in consideration of solubility and drying time. Examples of organic solvents include ester-based organic solvents such as ethyl acetate and methyl acetate; ketone-based organic solvents such as acetone and MEK; aromatic-based organic solvents such as benzene, toluene, and ethylbenzene; linear or cyclic aliphatic-based organic solvents such as heptane, hexane, and cyclohexane; and alcohol-based organic solvents such as isopropanol and butanol. Ethyl acetate and toluene are preferable as the organic solvent. These solvents may be used alone as one type or used in a mixture of two or more types. As a method for coating the pressure sensitive adhesive coating solution, it is possible to adopt a coating method known in the related art, for example, a roll coater method, a reverse roll coater method, a gravure roll method, a bar coating method, a comma coater method, a die coater method, or the like.

From the viewpoint of reducing thermal stress in the adhesive resin layer (A) and the base material layer 10 and reducing the shrinkage ratio described above of the adhesive film 50, the drying conditions of the coated pressure sensitive adhesive are preferably 10 seconds to 5 minutes at a temperature range of equal to or more than 100°C and equal to or less than 240°C. More preferably, drying is carried out for 30 seconds to 3 minutes in a temperature range of equal to or more than 120°C and equal to or less than 200°C.

### <Adhesive resin layer (B)>

The adhesive film 50 according to the present embodiment is provided with the adhesive resin layer (B) for which the adhesive force is reduced by an external stimulus, on the second surface 10B side on the opposite side to the first surface 10A of the base material layer 10.

Due to this, it is possible to easily peel the adhesive film 50 from the support substrate 80 by applying an external stimulus.

Here, examples of the adhesive resin layer (B) , the adhesive force of which is reduced by an external stimulus, include a heat-peelable adhesive resin layer, the adhesive force of which is reduced by heating, a radiation-peelable adhesive resin layer, the adhesive force of which is reduced by radiation, and the like. Among the above, a heat-peelable adhesive resin layer, the adhesive force of which is reduced by heating, is preferable.

Examples of the heat-peelable adhesive resin layer include adhesive resin layers formed of a heat-expandable pressure sensitive adhesive including a gas generating component, a heat-expandable pressure sensitive adhesive including heat-expandable microspheres capable of expanding to reduce the adhesive force, a heat-expandable pressure sensitive adhesive, the adhesive force of which is reduced by the cross-linking reaction of the adhesive components by heat, or the like.

In the present embodiment, the heat-expandable pressure sensitive adhesive used in the adhesive resin layer (B) is a pressure sensitive adhesive, the adhesive force of which is reduced or lost by heating at a temperature exceeding 180°C, for example. For example, it is possible to select a material which does not peel at a temperature of 180°C or lower and which does peel at a temperature exceeding 180°C and which preferably has an adhesive force such that the adhesive film 50 does not peel from the support substrate 80 during the electronic device manufacturing steps.

Here, it is possible to evaluate the reduction or loss of the adhesive force by heating at a temperature exceeding 180°C, for example, by the peeling strength from a stainless-steel plate, measured after attaching the adhesive resin layer (B) side to the stainless-steel plate, performing a heating treatment at 140°C for one hour, and then heating at a temperature exceeding 180°C for two minutes. The specific heating temperature when heating at a temperature exceeding 180°C is set to a temperature higher than the temperature at which gas is generated or the temperature at which the heat-expandable microspheres heat-expand and is set as appropriate depending on the type of gas to be generated or the heat-expandable microspheres. In the present embodiment, loss of adhesive force means, for example, a case where the 180° peeling strength measured under conditions of 23°C and a tensile speed of 300 mm/min is less than 0.5 N/25 mm.

As the gas generating component used in the heat-expandable pressure sensitive adhesive, for example, it is possible to use an azo compound, an azide compound, a Meldrum's acid derivative, or the like. In addition, it is also possible to use inorganic foaming agents such as ammonium carbonate, ammonium hydrogen carbonate, sodium hydrogen carbonate, ammonium nitrite, sodium borohydride, and various azides, or water; salts of fluoroalkane-based compounds such as trichloromonofluoromethane and dichloromonofluoromethane; azo-based compounds such as azobisisobutyronitrile, azodicarbonamide, and barium azodicarboxylate; hydrazine-based compounds such as paratoluenesulfonyl hydrazide, diphenylsulfone-3,3'-disulfonylhydrazide, 4,4'-oxybis(benzenesulfonyl hydrazide) and allylbis(sulfonylhydrazide); semicarbazide-based compounds such as p-toluylenesulfonyl semicarbazide, and 4,4'-oxybis(benzenesulfonyl semicarbazide); triazole-based compounds such as 5-morpholyl-1,2,3,4-thiatriazole; organic foaming agents such as N-nitroso compounds such as N,N'-dinitrosopentamethylenetetramine, and N,N'-dimethyl-N,N'-dinitrosoterephthalamide, and the like. The gas generating component may be added to the adhesive resin (B1) or may be directly bonded to the adhesive resin (B1).

As the heat-expandable microspheres used for the heat-expandable pressure sensitive adhesive, for example, it is possible to use a microencapsulated foaming agent. Examples of such heat-expandable microspheres include microspheres in which a substance that is easily gasified and expanded by heating such as isobutane, propane, and pentane is sealed in a shell having elasticity, or the like. Examples of the material forming the shell include vinylidene chloride-acrylonitrile copolymer, polyvinyl alcohol, polyvinyl butyral, polymethyl methacrylate, polyacrylonitrile, polyvinylidene chloride, polysulfone, and the like. It is possible to manufacture heat-expandable microspheres by, for example, a coacervation method, an interfacial polymerization method, or the like.

It is possible to add heat-expandable microspheres to the adhesive resin.

It is possible to appropriately set the content of at least one selected from the gas generating component and the heat-expandable microspheres according to the expansion ratio and the reduction in adhesive force of the heat-peelable adhesive resin layer (B) and the like without being particularly limited; however, for example, with respect to 100 parts by mass of the adhesive resin (B1) in the heat-peelable adhesive resin layer (B), the content is, for instance, 1 part by mass or more and 150 parts by mass or less, preferably 10 parts by mass or more and 130 parts by mass or less, and more preferably 12 parts by mass or more and 100 parts by mass or less.

It is preferable to implement the design such that the temperature at which gas is generated or the temperature at which heat-expandable microspheres undergo heat expansion is exceeding 180°C.

Examples of the adhesive resin (B1) forming the heat-expandable pressure sensitive adhesive include a (meth) acrylic-based resin (b), a urethane-based resin, a silicone-based resin, a polyolefin-based resin, a polyester-based resin, a polyamide-based resin, a fluorine-based resin, a styrene-diene block copolymer-based resin, and the like. Among these, the (meth)acrylic-based resin (b) is preferable.

Examples of the (meth) acrylic-based adhesive resin (b) used for the adhesive resin layer (B) include a copolymer including a (meth) acrylic acid alkyl ester monomer unit (b1) and a monomer unit (b2) having a functional group able to react with a cross-linking agent.

In the present embodiment, the (meth)acrylic acid alkyl ester means an acrylic acid alkyl ester, a methacrylic acid alkyl ester, or a mixture thereof.

It is possible to obtain the (meth) acrylic-based adhesive resin (b) according to the present embodiment, for example, by copolymerizing a monomer mixture including a (meth) acrylic acid alkyl ester monomer (b1) and a monomer (b2) having a functional group able to react with a cross-linking agent.

The monomer (b1) forming the (meth)acrylic acid alkyl ester monomer unit (b1) includes (meth)acrylic acid alkyl esters having an alkyl group of approximately 1 to 12 carbon atoms. A (meth) acrylic acid alkyl ester having an alkyl group having 1 to 8 carbon atoms is preferable. Specific examples thereof include methyl acrylate, methyl methacrylate, ethyl acrylate, ethyl methacrylate, butyl acrylate, butyl methacrylate, 2-ethylhexyl acrylate, 2-ethylhexyl methacrylate, and the like. These may be used alone or in a combination of two or more types. In the (meth)acrylic-based adhesive resin (b) according to the present embodiment, the content of the (meth) acrylic acid alkyl ester monomer unit (b1) is preferably 10% by mass or more and 98.9% by mass or less when the total of all monomer units in the (meth)acrylic-based adhesive resin (b) is 100% by mass, more preferably 50% by mass or more and 97% by mass or less, and even more preferably 85% by mass or more and 95% by mass or less.

Examples of the monomers (b2) forming the monomer (b2) having a functional group able to react with the cross-linking agent include acrylic acid, methacrylic acid, itaconic acid, mesaconic acid, citraconic acid, fumaric acid, maleic acid, itaconic acid monoalkyl ester, mesaconic acid monoalkyl ester, citraconic acid monoalkyl ester, fumaric acid monoalkyl ester, maleic acid monoalkyl ester, glycidyl acrylate, glycidyl methacrylate, acrylic acid-2-hydroxyethyl, methacrylic acid-2-hydroxyethyl acrylate, acrylamide, methacrylamide, tert-butylaminoethyl acrylate, tert-butylaminoethyl methacrylate, and the like. Acrylic acid, methacrylic acid, acrylic acid-2-hydroxyethyl, methacrylic acid-2-hydroxyethyl, acrylamide, methacrylamide, and the like are preferable. These may be used alone or in a combination of two or more types.

In the (meth)acrylic-based adhesive resin (b) according to the present embodiment, the content of the monomer unit (b2) is preferably 1% by mass or more and 40% by mass or less when the total of all monomer units in the (meth) acrylic-based adhesive resin (b) is 100% by mass, more preferably 1% by mass or more and 20% by mass or less, and even more preferably 1% by mass or more and 10% by mass or less.

The (meth)acrylic-based adhesive resin (b) according to the present embodiment may further include, in addition to the monomer unit (b1) and the monomer unit (b2), a bifunctional monomer unit (b3) and a specific comonomer (referred to below as a polymerizable surfactant) unit having properties as a surfactant.

The polymerizable surfactant has a property of copolymerizing with monomer (b1), monomer (b2), and monomer (b3) and also acts as an emulsifier in a case where emulsion polymerization is performed.

Examples of the monomers (b3) forming the bifunctional monomer units (b3) include allyl methacrylate, allyl acrylate, divinylbenzene, vinyl methacrylate, vinyl acrylate, trimethylolpropane tri(meth)acrylate, pentaerythritol tri(meth)acrylate, dipentaerythritol hexa(meth)acrylate, tetraethylene glycol di(meth)acrylate, or examples that the structure of the main chain is a propylene glycol-type with diacrylate or dimethacrylate at both ends (for example, manufactured by NOF Corp., trade name: PDP-200, PDP-400, ADP-200, and ADP-400), tetramethylene glycol type examples (for example, manufactured by NOF Corp., trade name: ADT-250 and ADT-850), and mixed types thereof (for example, manufactured by NOF Corp., trade name: ADET-1800 and ADPT-4000).

In the (meth)acrylic-based adhesive resin (b) according to the present embodiment, the content of the monomer unit (b3) is preferably 0.1% by mass or more and 30% by mass or less when the total of all monomer units in the (meth)acrylic-based adhesive resin (b) is 100% by mass, more preferably 0.1% by mass or more and 15% by mass or less, even more preferably 0.1% by mass or more and 20% by mass or less, and particularly preferably 0.1% by mass or more and 5% by mass or less.

Examples of the polymerizable surfactant include a surfactant that a polymerizable 1-propenyl group is introduced into a benzene ring of polyoxyethylene nonylphenyl ether (manufactured by Daiichi Kogyo Seiyaku Co., Ltd., trade name: Aqualon RN-10, RN-20, RN-30, RN-50, and the like), a surfactant that a polymerizable 1-propenyl group is introduced into a benzene ring of ammonium salt of sulfuric acid ester of polyoxyethylene nonylphenyl ether (manufactured by Daiichi Kogyo Seiyaku Co., Ltd., trade name: Aqualon HS-10, HS-20, HS-1025, and the like), and a sulfosuccinate diester-based surfactant having a polymerizable double bond in the molecule (manufactured by Kao Corp., trade name: Latemul S-120A, S-180A, and the like), or the like.

In the (meth)acrylic-based adhesive resin (b) according to the present embodiment, the content of the polymerizable surfactant is preferably 0.1% by mass or more and 30% by mass or less when the total of all monomer units in the (meth) acrylic-based adhesive resin (b) is 100% by mass, more preferably 0.1% by mass or more and 15% by mass or less, even more preferably 0.1% by mass or more and 20% by mass or less, and particularly preferably 0.1% by mass or more and 5% by mass or less.

The (meth)acrylic-based adhesive resin (b) according to the present embodiment may further contain a monomer unit formed of a monomer having a polymerizable double bond such as vinyl acetate, acrylonitrile, or styrene, as necessary.

Examples of the polymerization reaction mechanism of the (meth)acrylic-based adhesive resin (b) according to the present embodiment includes radical polymerization, anionic polymerization, cationic polymerization, and the like. In consideration of the manufacturing cost of the (meth)acrylic-based adhesive resin (b), the influence of functional groups of the monomer, the influence of ions on the surface of the electronic component, and the like, polymerization by radical polymerization is preferable.

When polymerizing by a radical polymerization reaction, examples of radical polymerization initiators include organic peroxides such as benzoyl peroxide, di-t-butyl peroxide, dicumyl peroxide, 3,3,5-trimethylhexanoyl peroxide, di-2-ethylhexylperoxy dicarbonate, methyl ethyl ketone peroxide, t-butylperoxyphthalate, t-butylperoxybenzoate, di-t-butylperoxyacetate, t-butylperoxyisobutyrate, t-butylperoxy-2-hexanoate, t-butylperoxy-2-ethylhexanoate, t-butylperoxy-3,5,5-trimethylhexanoate, acetyl peroxide, isobutyryl peroxide, octanoyl peroxide, t-butyl peroxide, and di-t-amyl peroxide; inorganic peroxides such as ammonium persulfate, potassium persulfate, and sodium persulfate; azo compounds such as 2,2'-azobisisobutyronitrile, 2,2'-azobis-2-methylbutyronitrile, and 4,4'-azobis-4-cyanovaleric acid.

In a case of polymerizing by an emulsion polymerization method, among these radical polymerization initiators, inorganic peroxides such as water-soluble ammonium persulfate, potassium persulfate, and sodium persulfate, and azo compounds having a carboxyl group in the molecule such as water-soluble 4,4'-azobis-4-cyanovaleric acid are preferable. Considering the influence of ions on the surface of the electronic components, ammonium persulfate and azo compounds having a carboxyl group in the molecule such as 4,4'-azobis-4-cyanovaleric acid are more preferable, and azo compounds having a carboxyl group in the molecule such as 4,4'-azobis-4-cyanovaleric acid are particularly preferable.

From the viewpoint of carrying out peeling from the support substrate more stably, the adhesive resin layer (B) according to the present embodiment preferably further includes, in addition to the adhesive resin (B1), a cross-linking agent (B2) having two or more cross-linkable functional groups in one molecule.

The cross-linking agent (B2) having two or more cross-linkable functional groups in one molecule is used to react with the functional groups having the adhesive resin (B1) and adjust the adhesive force and aggregating force.

Examples of such cross-linking agents (B2) include epoxy compounds such as sorbitol polyglycidyl ether, polyglycerol polyglycidyl ether, pentaerythritol polyglycidyl ether, diglycerol polyglycidyl ether, glycerol polyglycidyl ether, neopentyl glycol diglycidyl ether, and resorcinol diglycidyl ether; isocyanate compounds such as tetramethylene diisocyanate, hexamethylene diisocyanate, toluene diisocyanate 3 adduct of trimethylolpropane, polyisocyanate, diphenylmethane diisocyanate, and tolylene diisocyanate; aziridine compounds such as trimethylolpropane tri-β-aziridinyl propionate, tetramethylolmethane-tri-β-aziridinyl propionate, N,N'-diphenylmethane-4,4'-bis(1-aziridinecarboxyamide), N,N'-hexamethylene-1,6-bis(1-aziridinecarboxyamide), N,N'-toluene 2,4-bis(1-aziridinecarboxyamide), and trimethylolpropane-tri-β-(2-methylaziridine) propionate; tetrafunctional epoxy compounds such as N,N,N',N'-tetraglycidyl-m-xylenediamine, and 1,3-bis(N,N'-diglycidylaminomethyl)cyclohexane; melamine-based compounds such as hexamethoxymethylol melamine, and the like. These may be used alone or in a combination of two or more types.

Among the above, it is preferable to include one type or two or more types selected from epoxy-based compounds, isocyanate-based compounds, and aziridine-based compounds.

Usually, the content of the cross-linking agent (B2) is preferably in a range where the number of functional groups in the cross-linking agent (B2) does not exceed the number of functional groups in the adhesive resin (B1). However, in a case where new functional groups are created in the cross-linking reaction, in a case where the cross-linking reaction is slow, and the like, the content thereof may be greater as necessary.

From the viewpoint of carrying out peeling from the support substrate more stably, the content of the cross-linking agent (B2) in the adhesive resin layer (B) is preferably 0.5 parts by mass or more and 4.0 parts by mass or less with respect to 100 parts by mass of the adhesive resin (B1), and more preferably 1.0 part by mass or more and 3.0 parts by mass or less.

The total content of the adhesive resin (B1) and the cross-linking agent (B2) in the adhesive resin layer (B) is preferably 50% by mass or more and 100% by mass or less when the entire adhesive resin layer (B) is 100% by mass, more preferably 70% by mass or more and 100% by mass or less, even more preferably 90% by mass or more and 100% by mass or less, and particularly preferably 95% by mass or more and 100% by mass or less. Due to this, it is possible to further suppress position shifting of electronic components in the sealing step.

The total content of at least one selected from the adhesive resin (B1), the cross-linking agent (B2), the gas generating component, and the heat-expandable microspheres in the adhesive resin layer (B) is preferably 50% by mass or more and 100% by mass or less when the entire adhesive resin layer (B) is 100% by mass, more preferably 70% by mass or more and 100% by mass or less, even more preferably 90% by mass or more and 100% by mass or less, and particularly preferably 95% by mass or more and 100% by mass or less.

In addition, in the adhesive film 50 according to the present embodiment, from the viewpoint of stably holding the electronic component on the adhesive resin layer (A) when peeling the support substrate from the adhesive resin layer (B) by reducing the adhesive force of the adhesive resin layer (B) by applying an external stimulus, the content of at least one selected from the gas generating component and heat-expandable microspheres in the adhesive resin layer (A) is preferably 0.1% by mass or less when the entire adhesive resin layer (A) is 100% by mass, more preferably 0.05% by mass or less, and even more preferably 0.01% by mass or less, and it is particularly preferable that the adhesive resin layer (A) does not include at least one selected from a gas generating component and heat-expandable microspheres.

The adhesive resin layer (B) according to the present embodiment preferably includes an adhesion-imparting resin in addition to the adhesive resin (B1) from the viewpoint of improving the adhesion to the support substrate. Containing an adhesion-imparting resin in the adhesive resin layer (B) is preferable for facilitating adjustment of the adhesion to the support substrate near room temperature. An adhesion-imparting resin that the softening point is 100°C or higher is preferable. Specific examples of adhesion-imparting resins include rosin-based resins such as rosin-based derivatives treated by esterification or the like; terpene-based resins such as α-pinene, β-pinene, dipentene, and terpene phenol; natural rosins such as gum, wood, and tall oil; petroleum resins hydrogenated, disproportionated, polymerized, or maleated with these natural rosins; coumaron-indene resins, and the like.

Among these, examples having a softening point in the range of equal to or more than 100°C and equal to or less than 160°C are more preferable and examples having a softening point in the range of equal to or more than 120°C and equal to or less than 150°C are particularly preferable. Using an adhesion-imparting resin with a softening point within the above range not only minimizes contamination and glue residue on the support substrate, but also further improves adhesion to the support substrate in a working environment. Furthermore, when a polymerized rosin ester-based adhesion-imparting resin is used as the adhesion-imparting resin, not only are contamination and glue residue on the support substrate minimized, but also adhesion to the support substrate in an environment of equal to or more than 80°C and equal to or less than 130°C is improved, and it is possible to more easily carry out the peeling from the support substrate after expansion of the heat-expandable microspheres.

The blending ratio of the adhesion-imparting resin may be appropriately selected such that it is possible to adjust the elastic modulus of the adhesive resin layer (B) within a predetermined numerical range as desired, without being particularly limited. However, in terms of the elastic modulus of the adhesive resin layer (B) and the initial peeling force, 1 to 100 parts by mass with respect to 100 parts by mass of the adhesive resin (B1) is preferable. When the blending ratio of the adhesion-imparting resin is the lower limit value described above or more with respect to 100 parts by mass of the adhesive resin (B1), there is a tendency for the adhesion to the support substrate during work to be favorable.

On the other hand, when the blending ratio is the upper limit value described above or less, there is a tendency for the attachment property to the support substrate at room temperature to be favorable. In terms of the adhesion with the support substrate and the attachment property at room temperature, the blending ratio of the adhesion-imparting resin is preferably 2 to 50 parts by mass with respect to 100 parts by mass of the adhesive resin (B1). In addition, the acid value of the adhesion-imparting resin is preferably 30 or less. When the acid value of the adhesion-imparting resin is the upper limit value described above or less, there is a tendency for it to be difficult for glue residue to be left on the support substrate during peeling.

The thickness of the adhesive resin layer (B) is not particularly limited, but, for example, is preferably 5 µm or more and 300 µm or less, and more preferably 20 µm or more and 150 µm or less.

It is possible to form the adhesive resin layer (B), for example, by coating a pressure sensitive adhesive on the base material layer 10. The pressure sensitive adhesive may be dissolved in a solvent and coated as a coating solution, may be coated as an aqueous emulsion, or the liquid pressure sensitive adhesive may be coated directly.

Among the above, a pressure sensitive adhesive coating solution dissolved in an organic solvent is preferable. The organic solvent is not particularly limited and may be appropriately selected from known organic solvents in consideration of solubility and drying time. Examples of organic solvents include ester-based organic solvents such as ethyl acetate and methyl acetate; ketone-based organic solvents such as acetone and MEK; aromatic-based organic solvents such as benzene, toluene, and ethylbenzene; linear or cyclic aliphatic-based organic solvents such as heptane, hexane, and cyclohexane; and alcohol-based organic solvents such as isopropanol and butanol. Ethyl acetate and toluene are preferable as the organic solvent. These solvents may be used alone as one type or used in a mixture of two or more types.

As a method for coating the pressure sensitive adhesive coating solution, it is possible to adopt a coating method known in the related art, for example, a roll coater method, a reverse roll coater method, a gravure roll method, a bar coating method, a comma coater method, a die coater method, or the like.

From the viewpoint of reducing thermal stress in the adhesive resin layer (A) and the base material layer 10 and reducing the above shrinkage ratio of the adhesive film 50, the drying conditions of the coated pressure sensitive adhesive are preferably 10 seconds to 5 minutes at a temperature range of equal to or more than 100°C and equal to or less than 240°C. More preferably, drying is carried out for 30 seconds to 3 minutes in a temperature range of 120°C and equal to or less than 200°C. Here, in a case where the adhesive resin layer (B) includes at least one selected from gas generating components and heat-expandable microspheres, the drying temperature of the coated pressure sensitive adhesive is preferably in a range not exceeding temperature at which gas is generated or the temperature at which heat-expandable microspheres undergo heat expansion.

### <Other Layers>

The adhesive film 50 according to the present embodiment may be further provided with, for example, an unevenness-absorbing layer, a shock-absorbing layer, an easy-adhesive layer, or the like between the base material layer 10 and the adhesive resin layer (A) or between the base material layer 10 and the adhesive resin layer (B), in a range that the effects of the present embodiment are not impaired.

The unevenness-absorbing layer is preferably formed by natural rubber, synthetic rubber, or a synthetic resin having rubber elasticity with a Shore D-type hardness of, for example, 50 or less, preferably 40 or less, according to ASTM D-2240 D-type Shore. The thickness of the unevenness-absorbing layer is, for example, 500 µm or less, preferably 5 to 300 µm, more preferably 10 to 150 µm.

Examples of synthetic rubbers or synthetic resins include synthetic rubbers such as nitrile, diene, and acrylic rubbers, thermoplastic elastomers such as polyolefin and polyester elastomers, and synthetic resins having rubber elasticity such as ethylene vinyl acetate copolymers, polyurethane, polybutadiene, and soft polyvinyl chloride. In the present embodiment, it is possible to use even polymers which are essentially rigid, such as polyvinyl chloride, when combined with a blending agent such as a plasticizer or a softener to provide rubber elasticity. In addition, it is also possible to preferably use the adhesive resins and the like listed in the adhesive resin layer (A) and adhesive resin layer (B) above to form the unevenness-absorbing layer.

### 2. Method for Manufacturing Electronic Device

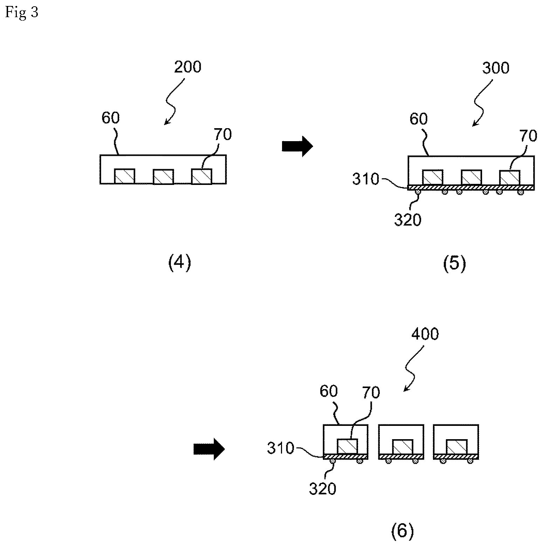

Next, a description will be given of the method for manufacturing an electronic device according to the present embodiment. Fig. 2 and Fig. 3 are cross-sectional views schematically showing an example of a method for manufacturing an electronic device of an embodiment according to the present invention.

The method for manufacturing an electronic device according to the present embodiment is provided with at least the following four steps.
(1) A step of preparing a structure 100 provided with the adhesive film 50, an electronic component 70 attached to the adhesive resin layer (A) of the adhesive film 50, and the support substrate 80 attached to the adhesive resin layer (B) of the adhesive film 50
(2) A step of sealing the electronic component 70 with a sealing material 60
(3) A step of peeling the support substrate 80 from the structure 100 by reducing the adhesive force of the adhesive resin layer (B) by applying an external stimulus
(4) A step of peeling the adhesive film 50 from the electronic component 70

In the method for manufacturing an electronic device according to the present embodiment, the adhesive film 50 according to the present embodiment described above is used as an adhesive film for temporarily fixing the electronic component 70.

A description will be given below of each step of the method for manufacturing an electronic device according to the present embodiment.

### (Step (1))

First, the structure 100 having the adhesive film 50, the electronic component 70 attached to the adhesive resin layer (A) of the adhesive film 50, and the support substrate 80 attached to the adhesive resin layer (B) of the adhesive film 50 is prepared.

It is possible to manufacture the structure 100, for example, by the following procedure.

First, on the support substrate 80, the adhesive film 50 is attached such that the adhesive resin layer (B) is on the support substrate 80 side. A protective film may be attached on the adhesive resin layer (B) and it is possible to peel the protective film and to attach the exposed surface of the adhesive resin layer (B) to the surface of the support substrate 80.

As the support substrate 80, for example, it is possible to use a quartz substrate, a glass substrate, a SUS substrate, or the like.

Next, it is possible to obtain the structure 100 by arranging the electronic components 70 on the adhesive resin layer (A) of the adhesive film 50 attached on the support substrate 80.

Examples of the electronic components 70 include semiconductor chips such as IC, LSI, discrete chips, light emitting diodes, and light receiving elements, semiconductor panels, semiconductor packages, and the like.

### (Step (2))

Next, the electronic component 70 is sealed with the sealing material 60.

The electronic component 70 is covered by the sealing material 60 and, for example, the sealing material 60 is cured at a temperature of 180°C or lower, to seal the electronic component 70. Here, in a case where the adhesive resin layer (B) of the adhesive film 50 includes at least one selected from gas generating components and heat-expandable microspheres, the temperature at which the sealing material 60 is cured is preferably in a range not exceeding the temperature at which gas is generated or the temperature at which heat-expandable microspheres undergo heat expansion.

In addition, the form of the sealing material 60 is not particularly limited, but is, for example, granular, sheet form, or liquid form.

The sealing material 60 is not particularly limited, but for example, it is possible to use an epoxy resin-based sealing material using an epoxy resin.

In particular, a liquid epoxy resin-based sealing material is preferable in terms of the affinity of the sealing material 60 to the adhesive film 50 being further improved and being able to seal the electronic components 70 more evenly.

As such epoxy resin-based sealing material, for example, it is possible to use the T693/R4000 series, the T693/R1000 series, the T693/R5000 series, and the like manufactured by Nagase ChemteX Corporation.

Examples of sealing methods include transfer molding, injection molding, compression molding, casting molding, and the like. After sealing the electronic component 70 with the sealing material 60, the sealing material 60 is cured by heating at, for example, a temperature of 180°C or lower and the structure 100 in which the electronic component 70 is sealed is obtained.

### (Step (3))

Next, the support substrate 80 is peeled from the structure 100 by reducing the adhesive force of the adhesive resin layer (B) by applying an external stimulus.

After sealing the electronic component 70, for example, it is possible to easily remove the support substrate 80 from the adhesive film 50 by heating to a temperature exceeding 180°C to reduce the adhesive force of the adhesive resin layer (B) .

### (Step (4))

Next, the adhesive film 50 is removed from the electronic component 70 to obtain the electronic device 200. Examples of methods for removing the adhesive film 50 from the electronic component 70 include a mechanical peeling method, a method of carrying out peeling after reducing the adhesive force of the adhesive film 50 surface, and the like.

### (Step (5))

In the method for manufacturing an electronic device according to the present embodiment, as shown in Fig. 3, a step (5) of forming a wiring layer 310 and bumps 320 on the exposed surface of the obtained electronic device 200 to obtain an electronic device 300 may be further provided.

The wiring layer 310 is provided with pads (not shown), which are external connection terminals formed on the outermost surface, and wiring (not shown), which electrically connects the exposed electronic component 70 to the pads. The wiring layer 310 is able to be formed by methods known in the related art and may be a multilayer structure.

Then, it is possible to form the bumps 320 on the pads of the wiring layer 310 and obtain the electronic device 300. Examples of the bumps 320 include solder bumps, gold bumps, or the like. It is possible to form solder bumps, for example, by arranging a solder ball on the pad, which is an external connection terminal of the wiring layer 310, and heating and melting (reflowing) the solder. It is possible to form gold bumps by methods such as a ball bonding method, a plating method, and an Au ball transfer method.

### (Step (6))

In addition, in the method for manufacturing an electronic device according to the present embodiment, as shown in Fig. 3, a step (6) of dicing the electronic device 300 to obtain a plurality of electronic devices 400 may be further provided.

It is possible to perform the dicing of the electronic device 300 by a known method.

A description was given above of the embodiments of the present invention, but these are examples of the present invention and it is also possible to adopt various configurations other than the above.

Here, the present invention is not limited to the embodiments described above and modifications, improvements, and the like in a range that it is possible to achieve the object of the present invention are included in the present invention.

### [Examples]

A detailed description will be given below of the present invention using Examples, but the present invention is not limited thereto.

Details of the materials used to manufacture the adhesive film are as follows.

### <Adhesive resin Solution SA1>

In pure water subjected to deionization, 0.5 parts by mass of 4, 4'-azobis-4-cyanovaleric acid (manufactured by Otsuka Chemical Co., Ltd., trade name: ACVA) as a polymerization initiator, 78 parts by mass of n-butyl acrylate and 10 parts by mass of methyl methacrylate as the monomer (a1), 9 parts by mass of 2-hydroxyethyl methacrylate as the monomer (a2), and 3 parts by mass of a mixture (manufactured by DKS Co., Ltd., trade name, Aqualon HS-1025) that a polymerizable 1-propenyl group was introduced to a benzene ring of an ammonium salt of a sulfate ester of polyoxyethylene nonylphenyl ether as a polymerizable surfactant, were each charged, and emulsion polymerization was carried out for 8 hours at equal to or more than 70°C and equal to or less than 72°C under stirring to obtain an acrylic-based resin emulsion. The above was neutralized (pH=7.0) with ammonia water and an adhesive resin solution SA1 having a solid content concentration of 42.5% by mass was obtained.

### <Adhesive resin Solution SA2>

In pure water subjected to deionization, 0.5 parts by mass of ammonium persulfate as a polymerization initiator, 63 parts by mass of 2-ethylhexyl acrylate, 21 parts by mass of n-butyl acrylate, and 9 parts by mass of methyl methacrylate as the monomer (a1), 3 parts by mass of 2-hydroxyethyl methacrylate as the monomer (a2), 1 part by mass of polytetramethylene glycol diacrylate (NOF Corp., trade name: ADT-250) as the monomer (a3), and 2 parts by mass of a mixture (manufactured by DKS Co., Ltd., trade name, Aqualon HS-1025) that a polymerizable 1-propenyl group was introduced to a benzene ring of an ammonium salt of a sulfate ester of polyoxyethylene nonylphenyl ether as a polymerizable surfactant, were each charged, and emulsion polymerization was carried out for 8 hours at equal to or more than 70°C and equal to or less than 72°C under stirring to obtain an acrylic-based resin emulsion. The above was neutralized (pH=7.0) with ammonia water and an adhesive resin solution SA2 having a solid content concentration of 56.5% by mass was obtained.

### <Pressure Sensitive Adhesive Coating Solution A1>

By mixing each of 55 parts by mass of the adhesive resin solution SA1, 45 parts by mass of the adhesive resin solution SA2, 0.5 parts by mass of dimethyl ethanolamine, and 4 parts by mass of an epoxy-based compound (Ex-1610 manufactured by Nagase ChemteX Corporation), which is a cross-linking agent, a pressure sensitive adhesive coating solution A1 was obtained.

### <Adhesive resin Solution SB1>

In a mixed solvent including ethyl acetate and toluene, 0.5 parts by mass of t-butyl peroxy-2-ethyl hexanoate (manufactured by NOF Corp., trade name: Perbutyl O (registered trademark)) as a polymerization initiator, 35 parts by weight of 2-ethylhexyl acrylate, 40 parts by mass of n-butyl acrylate, and 15 parts by mass of ethyl acrylate as the monomer (b1), and 10 parts by mass of 2-hydroxyethyl methacrylate as the monomer (b2) were each charged, solution polymerization was carried out for 11 hours at equal to or more than 83°C and equal to or less than 87°C under stirring and an acrylic-based resin solution with a solid content concentration of 45% by mass was obtained. The above was used as the adhesive resin solution SB1.

### <Pressure Sensitive Adhesive Coating Solution B1>

100 parts by mass of the adhesive resin solution SB1 and 0.9 parts by mass (2 parts by mass with respect to 100 parts by mass of the adhesive resin) of an isocyanate-based cross-linking agent (manufactured by Mitsui Chemicals, Inc., trade name: Olester P49-75S) were each mixed, and the solid content concentration was adjusted to 40% by mass with ethyl acetate to obtain a pressure sensitive adhesive coating solution B1.

### <Pressure Sensitive Adhesive Coating Solution B2>

100 parts by mass of the adhesive resin solution SB1, 2.25 parts by weight (5 parts by mass with respect to 100 parts by mass of the adhesive resin) of a polymerized rosin ester-based pressure sensitive adhesion imparting agent (manufactured by Arakawa Chemical Industries, Ltd., trade name: PENSEL D-125), 1.2 parts by mass (2 parts by mass with respect to 100 parts by mass of the adhesive resin) of an isocyanate-based cross-linking agent (manufactured by Mitsui Chemicals, Inc., trade name: Olester P49-75S), and 6.75 parts by mass (15 parts by mass with respect to 100 parts by mass of the adhesive resin) of heat-expandable microspheres (manufactured by Sekisui Chemical Co., Ltd., trade name: Advancell EM-503) were each mixed, and the solid content concentration was adjusted to 30% by mass with ethyl acetate to prepare a pressure sensitive adhesive coating solution B2.

### <Adhesive resin Solution SC1>

In a mixed solvent including ethyl acetate and toluene, 0.3 parts by mass of t-butyl peroxy-2-ethyl hexanoate (manufactured by NOF Corp., trade name: Perbutyl O (registered trademark)) as a polymerization initiator, 72 parts by weight of butyl acrylate and 18 parts by mass of methyl methacrylate as a monomer (c1), 7 parts by mass of 2-hydroxymethacrylate as a monomer (c2), and 3 parts by mass of acrylic acid as a monomer (c3) were each charged, solution polymerization was carried out for 11 hours at equal to or more than 83°C and equal to or less than 87°C under stirring and an acrylic-based resin solution with a solid content concentration of 45% by mass was obtained. The above was used as an adhesive resin solution SC1.

### <Pressure Sensitive Adhesive Coating Solution C1>

100 parts by mass of the adhesive resin solution SC1 and 0.9 parts by mass (2 parts by mass with respect to 100 parts by mass of the adhesive resin) of an isocyanate-based cross-linking agent (manufactured by Mitsui Chemicals, Inc., trade name: Olester P49-75S), were each mixed, and the solid content concentration was adjusted to 40% with ethyl acetate to obtain a pressure sensitive adhesive coating solution C1.

### <Pressure Sensitive Adhesive Coating Solution C2>

100 parts by mass of the adhesive resin solution SC1, 2.25 parts by weight (5 parts by mass with respect to 100 parts by mass of the adhesive resin) of a polymerized rosin ester-based pressure sensitive adhesion imparting agent (manufactured by Arakawa Chemical Industries, Ltd., trade name: PENSEL D-125), 1.2 parts by mass (2 parts by mass with respect to 100 parts by mass of the adhesive resin) of an isocyanate-based cross-linking agent (manufactured by Mitsui Chemicals, Inc., trade name: Olester P49-75S), and 6.75 parts by mass (15 parts by mass with respect to 100 parts by mass of the adhesive resin) of heat-expandable microspheres (manufactured by Sekisui Chemical Co., Ltd., trade name: Advancell EM-503) were each mixed, and the solid content concentration was adjusted to 30% with ethyl acetate to prepare a pressure sensitive adhesive coating solution C2.

### [Example 1]

After coating the pressure sensitive adhesive coating solution A1 on a polyethylene terephthalate (PET) film 1 (uniaxially stretched film, thickness: 38 µm, shrinkage ratio in the MD direction: 1.2%, shrinkage ratio in the TD direction: 0.3%, (the MD direction was the direction of maximum thermal shrinkage), which was the base material layer, drying was carried out by heating at 120°C for 1 minute to form an adhesive resin layer (A) with a thickness of 13 µm. Next, the pressure sensitive adhesive coating solution B1 was coated on a separator and dried by heating at 120°C for 1 minute to form an unevenness-absorbing layer with a thickness of 20 µm. Next, the unevenness-absorbing layer with a thickness of 20 µm described above was transferred from the separator to the surface of the PET film 1 on the opposite side of the adhesive resin layer (A), then, the pressure sensitive adhesive coating solution B2 was coated on the unevenness-absorbing layer and drying was carried out by heating at 120°C for 1 minute to form an adhesive resin layer (B) with a thickness of 27 µm and obtain an adhesive film with an adhesive resin layer (B) .

Here, the PET film 1 was subjected to a stress relaxation treatment by a heating treatment.

The obtained adhesive film was subjected to the following evaluation. The obtained results are shown in Table 1.

### [Example 2]

An adhesive film was obtained by the same step as in Example 1, except that the thickness of the adhesive resin layer (A) was 6 µm.

The obtained adhesive film was subjected to the following evaluation. The obtained results are shown in Table 1.

### [Comparative Example 1]

After coating the pressure sensitive adhesive coating solution A1 on a polyethylene terephthalate (PET) film 1 (uniaxially stretched film, thickness: 38 µm, shrinkage ratio in the MD direction: 1.2%, shrinkage ratio in the TD direction: 0.3%, (the MD direction was the direction of maximum thermal shrinkage), which was the base material layer, drying was carried out by heating at 120°C for 1 minute to form an adhesive resin layer (A) with a thickness of 13 µm. Next, the pressure sensitive adhesive coating solution C1 was coated on a separator and dried by heating at 120°C for 1 minute to form an unevenness-absorbing layer with a thickness of 15 µm. Next, the unevenness-absorbing layer with a thickness of 20 µm described above was transferred from the separator to the surface of the PET film 1 on the opposite side of the adhesive resin layer (A), then, the pressure sensitive adhesive coating solution C2 was coated on the unevenness-absorbing layer and drying was carried out by heating at 120°C for 1 minute to form an adhesive resin layer (B) with a thickness of 30 µm and obtain an adhesive film with an adhesive resin layer (B) .

Here, the PET film 1 was subjected to a stress relaxation treatment by a heating treatment.

The obtained adhesive film was subjected to the following evaluation. The obtained results are shown in Table 1.

### <Evaluation>

### (1) Average Water Absorption Rate

The average water absorption rate of the adhesive films was measured using the following procedure.
1) Separators were attached to both surfaces of the adhesive films obtained in the Examples and Comparative Examples and the films were left in a clean room under an atmosphere of 25°C and 50% RH for 24 hours.
2) The separators of the adhesive films were peeled off on both surfaces to expose the adhesive surface and the adhesive film was heated in an oven set at 130°C for 30 minutes in a suspended state to remove the moisture in the adhesive films. Next, the mass of the adhesive film after heating and drying was measured, and this mass was set as W₁.
3) The adhesive film after heating and drying was left in a suspended state for 24 hours in the clean room described above under an atmosphere of 25°C and 50% RH to absorb water, then, the mass of the adhesive film was measured. This mass was set as W₂.
4) 100 × (W₂-W₁)/W₁ (%) is set as the absorption rate. The same measurement was repeated six times for each adhesive film and the average thereof was used as the average water absorption rate.

### (2) Position Shifting of Electronic Components in Sealing Step

The adhesive resin layer (B) sides of the adhesive films obtained in the Examples and Comparative Examples were adhered on a stainless-steel plate (ϕ310 mm, 1.5 mm thickness) for compression molding and 5.0 mm square semiconductor chips as electronic components were placed on and adhered to the adhesive resin layer (A) of the adhesive film so as to form a grid at 2.0 mm intervals, thereby obtaining a structure.

Next, using a compression molding machine, a plurality of semiconductor chips on the adhesive resin layer (A) were sealed by compression molding with a liquid epoxy resin-based sealing material (manufactured by Nagase ChemteX Corporation, trade name:
T693/R4212-2C), and a structure was obtained in which a sealed resin wafer (ϕ300 mm, thickness 0.5 mm) was formed on a stainless-steel plate.

Next, the position shifting of the electronic components was evaluated according to the following criteria.

No: no position shifting of the semiconductor chips was observed visually

Yes: Position shifting was observed visually in at least some of the semiconductor chips

### [Table 1]

**[Table 1]**

| | Example 1 | Example 2 | Comparative Example 1 |
|---|---|---|---|
| Average water absorption rate (%) | 0.64 | 0.56 | 0.92 |
| Position shifting of semiconductor chips | No | No | Yes |

In the Examples using the adhesive film with an average water absorption rate of 0.90% by mass or less, no position shifting of the semiconductor chips in the sealing step was observed. Thus, it is understood that the adhesive films in the Examples are able to suppress the position shifting of the electronic components in the sealing step.

In contrast, in the Comparative Examples using an adhesive film with a shrinkage ratio in a range of more than 0.90%, position shifting of the semiconductor elements in the sealing step was observed. Thus, it is understood that, in the adhesive films of the Comparative Examples, position shifting of the electronic components in the sealing step was generated.

This application claims priority based on Japanese application JP 2019-086215 filed on April 26, 2019, the entire disclosure of which is incorporated herein.

### REFERENCE SIGNS LIST

- A:: adhesive resin layer
- B:: adhesive resin layer
- 10:: base material layer
- 10A:: first surface
- 10B:: second surface
- 50:: adhesive film
- 60:: sealing material
- 70:: electronic component
- 80:: support substrate
- 100:: structure
- 200:: electronic device
- 300:: electronic device
- 310:: wiring layer
- 320:: bump
- 400:: electronic device

## Claims

1. An adhesive film comprising:
a base material layer;
an adhesive resin layer (A) provided on a first surface side of the base material layer; and
an adhesive resin layer (B) provided on a second surface side of the base material layer and of which an adhesive force is reduced by an external stimulus,
wherein, when a mass of the adhesive film after being heated and dried at 130°C for 30 minutes is defined as W₁ and a mass of the adhesive film after the heated and dried adhesive film is left for 24 hours at 25°C under an atmosphere of 50% RH to absorb water is defined as W₂, an average water absorption rate indicated by 100 x (W₂-W₁) /W₁ is 0.90% by mass or less.

2. The adhesive film according to claim 1,
wherein the adhesive film is used to temporarily fix an electronic component when the electronic component is sealed by a sealing material in an electronic device manufacturing process.

3. The adhesive film according to claim 1 or 2,
wherein the base material layer includes a uniaxially stretched or biaxially stretched polyester film.

4. The adhesive film according to any one of claims 1 to 3,
wherein the adhesive force of the adhesive resin layer (B) is reduced upon being heated at a temperature exceeding 180°C.

5. The adhesive film according to claim 4,
wherein the adhesive resin layer (B) includes at least one selected from a gas generating component and heat-expandable microspheres.

6. The adhesive film according to any one of claims 1 to 5,
wherein a content of at least one selected from a gas generating component and heat-expandable microspheres in the adhesive resin layer (A) is 0.1% by mass or less when the entire adhesive resin layer (A) is 100% by mass.

7. The adhesive film according to any one of claims 1 to 6,
wherein the adhesive resin layer (A) includes a (meth)acrylic-based adhesive resin.

8. A method for manufacturing an electronic device, the method comprising at least:
a step (1) of preparing a structure provided with the adhesive film according to any one of claims 1 to 7, an electronic component attached to the adhesive resin layer (A) of the adhesive film, and a support substrate attached to the adhesive resin layer (B) of the adhesive film;
a step (2) of sealing the electronic component with a sealing material;
a step (3) of peeling the support substrate from the structure by reducing an adhesive force of the adhesive resin layer (B) by applying an external stimulus; and
a step (4) of peeling the adhesive film from the electronic component.

9. The method for manufacturing an electronic device according to claim 8,
wherein the sealing material is an epoxy resin-based sealing material.
